(19) Europäisches Patentamt
European Patent Office
Office européen des brevets

(11) **EP 3 144 989 A1**

(12) **EUROPÄISCHE PATENTANMELDUNG**

(43) Veröffentlichungstag:
**22.03.2017 Patentblatt 2017/12**

(51) Int Cl.:
***H01L 51/42*** *(2006.01)*

(21) Anmeldenummer: **15185466.8**

(22) Anmeldetag: **16.09.2015**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA**

(71) Anmelder:
• **ThyssenKrupp Steel Europe AG**
 **47166 Duisburg (DE)**
• **ThyssenKrupp AG**
 **45143 Essen (DE)**

(72) Erfinder:
• **Dr. Ehlers, Jan-Eric**
 **44225 Dortmund (DE)**
• **Dr. Glass, Roman**
 **44135 Dortmund (DE)**
• **Dr. Puls, Stefan Peter**
 **44141 Dortmund (DE)**
• **Dr. Schauer-Paß, Janine**
 **44803 Bochum (DE)**

(74) Vertreter: **Cohausz & Florack**
 **Patent- & Rechtsanwälte**
 **Partnerschaftsgesellschaft mbB**
 **Bleichstraße 14**
 **40211 Düsseldorf (DE)**

(54) **FESTKÖRPER-PHOTOVOLTAIKELEMENT**

(57) Die Erfindung stellt ein nach Art einer Hetero-Junction Solarzelle aufgebautes Photovoltaikelement zur Verfügung, das kostengünstig erzeugt werden kann, hohen mechanischen Belastungen standhält und einfach weiterverarbeitet werden kann. Hierzu weist ein erfindungsgemäßes Festkörper-Photovoltaikelement einen aus einem Stahlsubstrat bestehenden Träger (1) und einen von dem Träger (1) getragenen photovoltaisch aktiven Schichtaufbau auf, wobei dem Schichtaufbau und dem Träger (1) eine elektrisch isolierende, ionendiffusionshemmende Isolierschicht (2) angeordnet ist und der Schichtaufbau eine aus einem metallischen Werkstoff bestehende Rückseitenelektrode (3), einen Lochleiter (4), eine mindestens eine Perowskit-Schicht umfassende photovoltaisch aktive Schicht (5), einen Elektronenleiter (6), eine im sichtbaren Bereich des Lichts transparente Frontelektrode (7) und eine im sichtbaren Bereich des Lichts transparente Schutzschicht (8) umfasst.

Fig. 1

EP 3 144 989 A1

**Beschreibung**

Die Erfindung betrifft ein Festkörper-Photovoltaikelement mit einem Träger und einem von dem Träger getragenen photovoltaisch aktiven Schichtaufbau.

So genannte "Hetero-Junction Solarzellen" mit Perowskitschichten aus photovoltaisch aktivem Material sind grundsätzlich bekannt. Kombiniert mit Elektrodenschichten, insbesondere einer aus einem transparenten leitfähigen Oxid, wie FTO (FTO = Fluorine Doped Tin Oxide), ITO- (ITO = Indium Tin Oxide) oder dotiertem Zinkoxide, gebildeten Anode, in der Fachsprache auch kurz als "TCO" (TCO = Transparent Conducting Oxide) bezeichnet, sowie einer Metall-Kathode, können sie unter Einbringung von geeigneten p- und n-Halbleiterschichten, wie beispielsweise OMeTAD und Titandioxid, auf Glasträgern aufgebracht werden (EP 2 693 503 A1).

Aus der EP 2 605 280 A1 ist des Weiteren ein metallisches Flacherzeugnis mit photovoltaisch wirksamer Beschichtung zur Bildung organischer Solarzellen bekannt. Hier ist das jeweilige Metallsubstrat an mindestens einer Seite mit einer elektrisch isolierenden Schicht ausgerüstet. Bei der photovoltaisch wirksamen Beschichtung handelt es sich um eine photoaktive Polymerschicht, die bereichsweise zwischen zwei elektrisch leitfähigen Schichten, Elektrode und Gegenelektrode, angeordnet ist.

Vor dem Hintergrund des voranstehend erläuterten Standes der Technik bestand die Aufgabe der Erfindung darin, ein nach Art einer Hetero-Junction Solarzelle aufgebautes Photovoltaikelement zu schaffen, das kostengünstig erzeugt werden kann, hohen mechanischen Belastungen standhält und einfach weiterverarbeitet werden kann.

Zur Lösung dieser Aufgabe schlägt die Erfindung ein Photovoltaikelement mit dem in Anspruch 1 angegebenen Aufbau vor.

Vorteilhafte Ausgestaltungen der Erfindung sind in den abhängigen Ansprüchen angegeben und werden nachfolgend wie der allgemeine Erfindungsgedanke im Einzelnen erläutert.

Ein erfindungsgemäßes Photovoltaikelement weist dementsprechend

- einen Träger, der aus einem metallischen Werkstoff besteht,
  und
- einen von dem Träger getragenen photovoltaisch aktiven Schichtaufbau
  auf, wobei
- zwischen dem photovoltaisch aktiven Schichtaufbau und dem Träger eine elektrisch isolierende, ionendiffusionshemmende Isolierschicht angeordnet ist und
- der photovoltaisch aktive Schichtaufbau folgende wie folgt geschichtete Funktionsschichten umfasst:
- eine aus einem metallischen Werkstoff bestehende Rückseitenelektrode,
- einen Lochleiter,
- eine mindestens eine Perowskit-Schicht umfassende photovoltaisch aktive Schicht,
- einen Elektronenleiter,
- eine im sichtbaren Bereich des Lichts transparente Frontelektrode und
- eine im sichtbaren Bereich des Lichts transparente Schutzschicht.

Allgemein lässt sich der Schichtaufbau eines erfindungsgemäßen Festkörper-Photovoltaikelements dabei kosteneffektiv durch kontinuierliche Applikation auf einem als Stahlflachprodukt vorliegenden Stahlsubstrat aufbringen. Dies kann in an sich bekannter Weise entweder nasschemisch von Rolle zu Rolle mit Druckverfahren, wie unter Einsatz von Spritz- oder Schlitzdüsen, oder physikalisch durch ein Gasabscheideverfahren erfolgen, wie beispielsweise ein PVD- ("PVD" = Physical Vapour Deposition), ein CVD- ("CVD" = Chemical Vapour Deposition) oder ALD-Verfahren ("ALD" = Atomic Layer Deposition), das gegebenenfalls plasmaunterstützt ausgeführt wird.

Zur Verbesserung der Absorption und damit einhergehend der Effizienz kann das Stahlsubstrat eines erfindungsgemäßen Festkörper-Photovoltaikelements auch mit einer Strukturierung versehen werden. Diese kann beispielsweise durch eine Laserbehandlung oder Walzen in das Substrat eingeprägt werden.

Entscheidend für die Erfindung ist, dass als Trägersubstrat nicht mehr eine Glasschicht, sondern ein aus einem metallischen Werkstoff bestehendes Trägerelement vorgesehen ist. Ein metallischer Träger hat nicht nur den Vorteil, dass er kostengünstig aus vergleichbar kostengünstigen Werkstoffen, wie beispielsweise einem Stahl-, insbesondere Edelstahl-, einem Leichtmetall-, insbesondere Aluminium-, oder einem Kupferwerkstoff hergestellt werden kann, sondern dass er auch eine hohe mechanische Widerstandsfähigkeit unter dynamisch wechselnden Belastungen zeigt. Gleichzeitig können metallische Trägermaterialien der erfindungsgemäß vorgesehenen Art leicht verarbeitet werden. Dabei ist es selbstverständlich ebenso denkbar, dass als Trägermaterial Verbundwerkstoffe verwendet werden, bei denen unterschiedliche Metallwerkstoffe insbesondere lagenweise miteinander kombiniert sind, um optimale Eigenschaften des Trägermaterials zu erreichen.

Typischerweise kommen als Stahlsubstrat bei einem erfindungsgemäßen Festkörper-Photovoltaikelement verzinkte Stahlbleche zum Einsatz, die auf ihrer Oberfläche eine gewisse Unebenheit aufweisen. Insbesondere bei solcherart beschichteten, aber auch bei anderen Stahlflachprodukt-Substraten, die eine gewisse Rauigkeit aufweisen, wirkt die Isolierschicht auch als Planarisierung, so dass eine optimal glatte Oberfläche für den photovoltaisch aktiven Schichtaufbau vorhanden ist. Der Ra-Wert (Mittlere Rauheit) sollte dabei kleiner als die verwendeten Schichtdicken des Schichtaufbaus sein, wobei dies vorzugsweise im entsprechenden Sinne auch für die Rautiefe Rt gilt.

Die Erfindung erlaubt es, als Träger jede Art von metallischem Bauelement zu nutzen, auf dem sich ein photovoltaisch aktiver Schichtaufbau der erfindungsgemäß vorgesehenen Art errichten lässt. Im Hinblick auf die heute üblichen Anwendungen und die heute zur Verfügung stehenden Möglichkeiten einer technisch betriebssicheren Herstellung eignen sich als Trägermaterial insbesondere metallische Flachprodukte, die walztechnisch hergestellt sind und im erfindungsgemäßen Photovoltaikelement eine metallische Trägerschicht bilden. Unter dem Begriff "Flachprodukt" werden dabei Bänder und Bleche oder daraus gewonnene Zuschnitte oder Platinen verstanden. Die Dicke des dann als erfindungsgemäßer Träger jeweils vorgesehenen Flachprodukts beträgt typischerweise 0,1 - 2 mm, wobei sich Dicken von 0,5 - 0,8 mm für die Trägerschicht als besonders zweckmäßig herausgestellt haben.

Überraschend hat sich gezeigt, dass bei einem erfindungsgemäßen Photovoltaikelement der metallische Träger allenfalls unwesentlichen Einfluss auf den Wirkungsgrad des Photovoltaikelements hat. Dies wird durch die erfindungsgemäß zwischen dem photovoltaisch aktiven Schichtaufbau und dem Träger vorgesehene elektrisch isolierende, ionendiffusionshemmende Isolierschicht erreicht. Die isolierende Schicht wird somit auf dem Träger aufgebracht, bevor der photovoltaisch aktive Schichtaufbau auf ihm aufgebaut wird.

Die als isolierende Barriere dienende Isolierschicht kann in Form einer organischen oder anorganischen Beschichtung ausgeführt sein. So eignen sich für die Isolierschicht polymerhaltige oder quarzhaltige Beschichtungen. Beispielsweise kann die Isolierschicht als ein aus dem Stand der Technik bekannter elektrisch isolierender Lack oder als eine SiO$_2$-Schicht aufgetragen werden. Typische Dicken der Isolierschicht liegen im Bereich von 0,5 - 150 $\mu$m, wobei sich Schichtdicken von bis zu 50 $\mu$m als besonders günstig erweisen. Wird für die Isolierschicht ein Lack und als Träger ein metallisches Flachprodukt verwendet, so kann der Isolierlack im Zuge der Herstellung des Träger-Flachprodukts mit jedem im Stand der Technik für den Auftrag von dünnen, dichten Lackschichten geeigneten Verfahren aufgetragen werden. Wird das Trägermaterial als Blech oder Band verarbeitet, bietet sich beispielsweise ein Rollenauftrag in einem konventionellen Coil-Coating-Verfahren an. Wird dagegen eine Quarzschicht vorgesehen, kann sie mit einem geeigneten Gasphasenabscheideverfahren (Physical Vapour Deposition "PVD" oder Chemical Vapour Deposition "CVD") auf dem jeweiligen Trägersubstrat abgeschieden werden.

Die Funktionsschichten des erfindungsgemäß vorgesehenen photovoltaisch aktiven Schichtaufbaus sind in einer Reihenfolge aufgebracht, die einerseits eine einfache Herstellbarkeit und andererseits einen optimierten Wirkungsgrad des erfindungsgemäßen Photovoltaikelements gewährleisten.

An seiner der Isolierschicht zugeordneten Rückseite weist der photovoltaisch aktive Schichtaufbau demnach eine aus einem metallischen Werkstoff bestehende Schicht auf, die als Rückseitenelektrode wirkt und in der praktischen Anwendung typischerweise als Kathode des Photovoltaikelements dient. Als Werkstoff für die Rückseitenelektroden-Schicht eignen sich beispielsweise Silber, Gold, Kupfer oder auch Aluminium, wobei diese Elemente nicht nur in technisch reiner Form verwendet, sondern jeweils auch Hauptbestandteil einer für die Rückseitenelektrode bestimmten Legierung sein können. Typische Dicken der Rückseitenelektroden-Schicht liegen im Bereich von 1 - 30 $\mu$m, insbesondere 5 - 20 $\mu$m. Derart dünne Metallschichten können ebenfalls besonders genau und gleichmäßig per Gasphasenabscheidung auf die Isolierschicht aufgetragen werden.

Auf der Rückseitenelektrodenschicht liegt bei einem erfindungsgemäß vorgesehenen photovoltaisch aktiven Schichtaufbau eine Lochleiterschicht. Diese Schicht ist typischerweise 0,05 - 0,5 $\mu$m dick und besteht aus einem der hierfür im Stand der Technik bekannten Materialen, wie sie beispielsweise in der EP 2 693 503 A1 für diesen Zweck beschrieben sind. Zu den in Frage kommenden Materialien zählt insbesondere Spiro-OMeTAD (2,2',7,7'-Tetrakis[N,N-di(4-methoxyphenyl)amino]-9,9'-spirobifluorene), das in Chlorbenzol gelöst beispielsweise durch Rotationsbeschichten, in der Fachsprache auch "Spin-Coating" genannt, oder ein anderes Dünnschicht-Beschichtungsverfahren, wie Siebdruck- oder Tintenstrahldruckverfahren auf der auf den Träger applizierten Isolierschicht aufliegenden Rückseitenelektrodenschicht aufgebracht werden kann. Denkbar ist es auch, die Lochleiterschicht in entsprechender Weise aus PEDOT-PSS (Poly(3,4)-ethylendioxithiophen - Polystyrolsulfonat), tert-butyl-Pyridin zu bilden, die in gleicher Weise appliziert werden können. Die Trocknung der jeweils applizierten Schicht kann dann unter Stickstoff und optionaler Wärmezufuhr erfolgen. Auf der Lochleiterschicht liegt bei einem erfindungsgemäßen Photovoltaikelement die eine photovoltaisch aktive Schicht.

Diese lässt sich durch metallorganische oder anorganische Verbindungshalbleiter realisieren. Insbesondere sind hier Perowskit-Funktionsschichten geeignet, wie sie beispielsweise aus der schon erwähnten EP 2 693 503 A1 bekannt ist. Wie dort im Einzelnen dargelegt, lassen sich Perowskitstrukturen der Form ABX$_3$ für die erfindungsgemäßen Zwecke einsetzen.

Allgemein gilt hier, dass im Falle der anorganischen Perowskite "A" ein Metall oder z.B. ein organisches Ammonium-Ion, "B" ein Metall, und "X$_3$" ein Anion ist, welches mit der Oxidationsstufe des Metalls B in der Regel variiert. Im Fall einer metallorganischen Persowskit-Verbindung stellt dagegen der Anteil "A" z.B. das Molekül Methyl-Ammonium

und der Anteil "$X_3$" z.B. ein Halogenid dar.

So handelt es sich im Fall der metallorganischen Perowskite bei der Komponente "A" der Formel $ABX_3$ um eine monovalente, positiv geladene organische Verbindung der Form $N^+R_1R_2R_3R_4$. Dabei sind $R_1, R_2, R_3, R_4$ unabhängig voneinander jeweils H oder ein Alkylrest oder ein Arylrest mit bis zu 25 Kohlenstoffatomen, wie beispielsweise im Fall eines Alkylrestes 1 - 20 Kohlenstoffatomen, insbesondere 1 - 12 Kohlenstoffatomen, oder im Fall eines Arylrestes 3 - 25 Kohlenstoffatomen, insbesondere 5 - 20 Kohlenstoffatomen. Beispiele für hierzu geeignete Verbindungen sind in großer Zahl in der EP 2 693 503 A1 aufgelistet.

Bei der Komponente "B" der Formel $ABX_3$ handelt es sich insbesondere um ein di- oder pentavalentes Kation, das aus der Gruppe "$Si^{2+}$, $Ge^{2+}$, $Pb^{2+}$, $P^{5+}$, $As^{5+}$, $Sb^{5+}$, $Bi^{5+}$, $Zn^{2+}$, $Cd^{2+}$, $Hg^{2+}$, $Cu^{2+}$, $Ag^{2+}$, $Au^{2+}$, $Ni^{2+}$, $Pd^{2+}$, $Pt^{2+}$, $Co^{2+}$, $Rh^{2+}$, $Ir^{2+}$, $Fe^{2+}$, $Ru^{2+}$, $Os^{2+}$, $Mn^{2+}$, $Tc^{2+}$, $Re^{2+}$, $Cr^{2+}$, $Mo^{2+}$, $W^{2+}$, $V^{2+}$, $Nb^{2+}$, $Ta^{2+}$, $Ti^{2+}$, $Zr^{2+}$ oder $Hf^{2+}$" ausgewählt werden kann. Nähere Erläuterungen finden sich auch hierzu in der EP 2 693 503 A1.

Schließlich wird in der Formel $ABX_3$ mit der Komponente "X" ein einfach oder zweifach negativ geladenes Ion bezeichnet, das aus der Gruppe "$F^-$, $Cl^-$, $Br^-$, $I^-$, $SCN^-$, $OCN^-$, $CN^-$, $O^{2-}$, $S^{2-}$, $Se^{2-}$ oder $Te^{2-}$" ausgewählt ist. Nähere Erläuterungen hierzu finden sich ebenfalls in der EP 2 693 503 A1.

Die erfindungsgemäße Perowskitstruktur weist dabei insbesondere eine Bandlücke Eg im sichtbaren oder nahinfraroten Bereich auf und kann zudem mit einem Toleranzfaktor t von 0,8 - 1,2 belegt sein, der nach folgender, an sich bekannter Formel berechnet wird (s. https://de.wikipedia.org/wiki/Perowskit):

$$t = \left(r_A + r_X\right)/\left(\sqrt{2}\left(r_B + r_X\right)\right)$$

Optimal für die erfindungsgemäßen Zwecke geeignete Perowskitstrukturen zeichnen sich durch einen Toleranzfaktor t von 0,97 - 1,03 aus.

Die der Perowskit-Summenformel $ABX_3$ zu Grunde liegende Reaktion lässt sich auch wie folgt beschreiben:

$$R\text{-}NH_2 + HX + MX_2 \rightarrow R\text{-}NH_3^+ + X^- + MX_2 \rightarrow CH_3\text{-}NH_3\text{-}M\text{-}X_3$$

(entspricht $ABX_3$, wobei B = Metall(M))

Organisches Molekül <u>**A**</u>: $R\text{-}NH_2$; R= Alkyl, iso-Alkyl, Aryl, ...

<u>**HX**</u>: Säure der Halogenide oder Pseudohalogenide bzw. Chalkogenide HSCN; HNCS; HI; HCl; HBr; HF; HCN; HNC; $H_2C_2$; $H_2S$; $H_2Se$, $H_2Te$

<u>**BX$_2$**</u>: z.B. $PbI_2$ oder $Pb(SCN)_2$ usw.

Anion X kann in Abhängigkeit der Oxidationsstufen des Metalls B variieren:

B(+2): X=Halogenid oder Pseudohalogenid, z.B. (Oxidationsstufe -1)

B(+5): X=Chalkogenid, z.B. Sauerstoff; Schwefel, Tellur, Selen (Oxidationsstufe -2)

Beispiele für aus Sicht der Erfindung besonders geeignete Kombinationen der Komponenten "A", "B" und "X" für gemäß der Form $ABX_3$ gebildete metallorganische Perowskit-Schichten sind in Tabelle 1 angegeben.

Die Gesamtschichtdicke der photovoltaisch aktiven Schicht liegt typischerweise im Bereich von 0,1 - 1,5 $\mu$m.

Auch die photovoltaisch aktive Perowskit-Schicht kann durch Gasphasenabscheidung, insbesondere PVD, eines geeigneten Precursors mit anschließender thermischer Nachbehandlung zielgerichtet auf der Lochleiterschicht abgeschieden werden. Die thermische Nachbehandlung kann dabei darin bestehen, dass das mit der Perwowskit-Schicht beschichtete Element über eine Dauer von 0,25 - 4 h bei 80 - 120 °C bei einem Druck von 1 bar unter einer $N_2$-Atmosphäre gehalten wird.

Auf die photovoltaisch aktive Schicht ist bei einem erfindungsgemäßen Photovoltaikelement eine dementsprechend ausgebildete Elektronenleiter-Schicht aufgetragen. Diese besteht typischerweise aus Verbindungen wie $TiO_2$, welche durch spin-coating mit anschließendem Trocknen und Calcinieren oder durch Magnetron-Sputtern (insbesondere bei Verwendung von $TiO_2$) aufgebracht werden kann. Die Trocknung kann bei 120 °C und das Calcinieren kann bei 500 °C erfolgen. Die Schichtdicke der Elektronenleiter-Schicht liegt dabei typischerweise im Bereich von 0,05 - 50 $\mu$m, wobei die Schichtdicke insbesondere 0,1 $\mu$m beträgt und es vorteilhaft sein kann, wenn die Schichtdicke auf 0,5 $\mu$m beschränkt ist.

Auf der Elektronenleiter-Schicht liegt beim photovoltaisch aktiven Schichtaufbau eines erfindungsgemäßen Photovoltaikelements eine Frontelektroden-Schicht, die in im Gebrauch üblicherweise die Anodenfunktion des Photovoltaikelements übernimmt. Hierbei ist von besonderer Bedeutung, dass die Frontelektrode aus einem im Absorptionsspektrum des Photovoltaikelements, insbesondere im sichtbaren Licht, transparenten Material besteht. Die Frontelektrodenschicht kann dazu aus ITO (Indium Tin Oxide) oder FTO (Fluorine Doped Tin Oxide) gebildet sein und durch Magnetronsputtern auf der Elektronenleiterschicht abgeschieden sein. Die Dicke der Frontelektroden-Schicht liegt hier typischerweise bei von 0,05 - 1 $\mu$m.

Auf der Frontelektroden-Schicht liegt beim photovoltaisch aktiven Schichtaufbau eines erfindungsgemäßen Photovoltaikelements schließlich eine ebenfalls transparente Schutzschicht. Diese den äußeren Abschluss des Photovoltaikelements auf seiner dem Träger gegenüberliegenden Seite bildende Deckschicht kann durch ein Gasphasenabscheideverfahren oder durch Rollenkaschieren auf der Frontelektroden-Schicht aufgetragen und 0,1 - 50 $\mu$m dick sein. Insbesondere kann die Deckschicht auch als Folie oder Lack aufgetragen sein. Als Materialien für die Schutzschicht besonders geeignet haben sich Quarzmaterialien, wie $SiO_2$, oder für diese Zwecke bekannte Folien erwiesen. Die Quarzmaterialien können auch durch Elektronenstrahlbedampfung auf der Frontseitenelektroden-Schicht abgeschieden werden.

Eine Zusammenfassung des erfindungsgemäßen Aufbaus eines Photovoltaikelements, der besonders in Frage kommenden Materialien und Beschichtungsmethoden findet sich in Tabelle 2.

Es ist bekannt, dass es zur Optimierung der Wirkungsgrade von Photovoltaikelementen zweckmäßig ist, die hinsichtlich der erzielbaren Leistung relevanten Schichten derart zu strukturieren, dass sie in photovoltaisch aktive Zellen unterteilt sind. Diese Zellen können durch Serienschaltung so miteinander verkoppelt werden, dass das Photovoltaikelement hohe Spannungen bei hohen Strömen und damit eine insgesamt hohe Leistung liefert. Die der Strukturierung zu Grunde liegenden Überlegungen und Effekte sind im Artikel "Novel industrial approaches in solar-cell production" von Aart Schoonderbeek und Andreas Ostendorf, veröffentlicht unter der URL http://spie.org/x25041.xml, DOI: 10.1117/2.1200804.1132, erläutert.

Die Strukturierung lässt sich über strukturiertes Drucken oder Aufdampfen erzielen ("additiver Prozess") oder über vollflächige Abscheidung und anschl. selektive Entfernung der Schichten durch Ätzen oder Laserbehandeln (subtraktiver Prozess) erzeugen. Bei der Laserstrukturierung hat sich die oben genannte Nomenklatur P1, P2 und P3 eingebürgert.

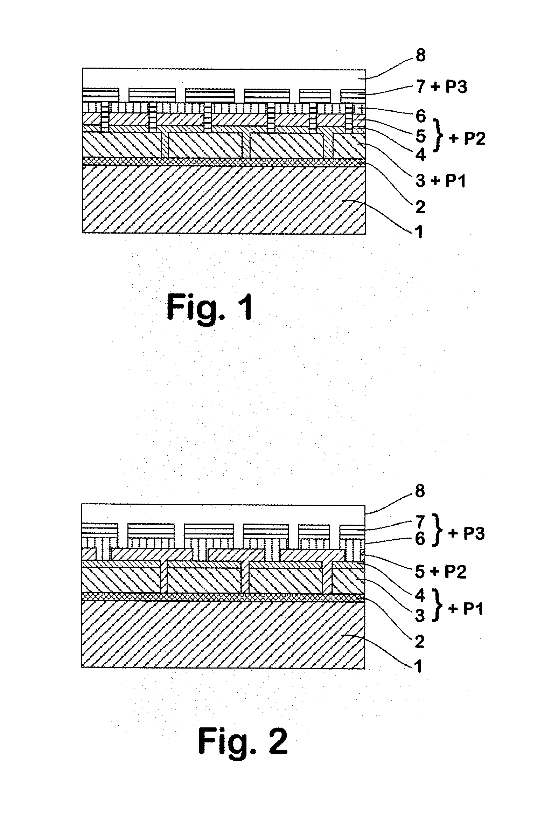

Unter Verwendung dieser Nomenklatur ergibt sich dann nach einer ersten Variante die in Fig. 1 dargestellte Abfolge der Schichten Träger 1, Isolierschicht 2, Rückseitenelektroden-Schicht 3 mit Strukturierung P1, gemeinsam mit der Strukturierung P2 versehene Lochleiter-Schicht 4, photoaktive Schicht 5 und Elektronenleiter-Schicht 6, Frontelektrode 7 mit Strukturierung P3, Schutzschicht 8.

In Fig. 2 ist eine alternative zweite Variante der Schicht- und Strukturierungsabfolge der Schichten Träger 1, Isolierschicht 2, gemeinsam mit der Strukturierung P1 versehene Rückseitenelektroden-Schicht 3 und Lochleiter-Schicht 4, photoaktive Schicht 5 mit Strukturierung P2, gemeinsam mit der Strukturierung P3 versehene Elektronenleiter-Schicht 6 und Frontelektrode 7, Schutzschicht 8.

Erfindungsgemäße Photovoltaikelemente erreichen zuverlässig Wirkungsgrade von mindestens 10 %, insbesondere mindestens 15 % oder mindestens 17 %.

Entsprechend den voranstehenden Erläuterungen wird bei der erfindungsgemäßen Erzeugung eines Photovoltaikelements wie folgt vorgegangen:

Arbeitsschritt 1: Es wird ein metallischer Träger 1, insbesondere in Form eines metallischen Flachprodukts, bereitgestellt.

Arbeitsschritt 2: Auf den Träger 1 wird die als elektrisch isolierende Barriere wirkende Isolierschicht 2 aufgetragen.

Anschließend wird auf der Isolierschicht 2 der photovoltaisch aktive Schichtaufbau gebildet. Dazu werden

Arbeitsschritt 3: auf die Isolierschicht 2 die als Kathode wirkende Rückseitenelektroden-Schicht 3,

Arbeitsschritt 4: auf die Rückseitenelektroden-Schicht 3 die Lochleiterschicht 4,

Arbeitsschritt 5: auf die Lochleiterschicht die photovoltaisch aktive Schicht 5,

Arbeitsschritt 6: auf die photovoltaisch aktive Schicht 5 die Elektronenleiterschicht 6,

Arbeitsschritt 7: auf die Elektronenleiterschicht 6 die Frontseitenelektroden-Schicht 7

und

Arbeitsschritt 8: auf die Frontseitenelektroden-Schicht 7 die Schutzschicht 8
aufgebracht.

Abhängig davon, welche der beiden oben bereits erläuterten Alternativen der Strukturierung gewählt wird, erfolgt (Alternative 1) in oder jeweils nach den Arbeitsschritten 3, 6 und 7 die Rückseitenelektroden-Schicht 3 alleine, die Lochleiter-Schicht 4, die photoaktive Schicht 5 und die Elektronenleiter-Schicht 6 gemeinsam und die Frontseitenelektroden-Schicht 7 alleine bereits strukturiert zu einzelnen Zellen aufgeteilt aufgebracht oder die jeweilige(n) Schicht(en) 3, (4,5,6), 7 werden nach dem Auftrag beispielsweise durch eine Laserbehandlung strukturiert.

Bei der Alternative 2 der Strukturierung werden dagegen in oder jeweils nach den Arbeitsschritten 4, 5 und 7 die Rückseitenelektroden-Schicht 3 gemeinsam mit der Lochleiter-Schicht 4, die photoaktive Schicht 5 alleine und die Elektronenleiter-Schicht 6 gemeinsam mit der Frontseitenelektroden-Schicht 7 bereits strukturiert zu einzelnen Zellen aufgeteilt aufgebracht oder die jeweilige(n) Schicht(en) 3, (4,5,6), 7 werden nach dem Auftrag beispielsweise durch eine Laserbehandlung strukturiert.

Nachfolgend wird die Erfindung anhand von Ausführungsbeispielen erläutert.

Beispiel 1 (nasschemische Route)

Auf ein als Träger dienendes Stahlflachprodukt 1 wird per Rolle nasschemisch ein Haftvermittler auf Basis von Zirkonoxid oder Kobaltoxid mit einer Dicke von 1 - 2 $\mu$m appliziert. Darauf wird ebenfalls mittels Rollenapplikation ein zinkhaltiger Korrosionsschutzprimer in einer Dicke von 3 - 5 $\mu$m aufgebracht. Darauf wird wiederum mittels Rollenapplikation als Isolierschicht 2 ein Polyvinyldifluorid(PVDF)-Lack in einer Dicke von 10 - 100 $\mu$m aufgetragen.

Auf die Isolierschicht 2 wird nun durch Rakeln von Silberleitpaste und anschließende Wärmebehandlung bei 100 - 150 °C für max. 0,5 h die elektrisch leitfähige, als Kathode dienende Rückseitenelektroden-Schicht 3 gebildet. Alternativ kann als Rückseitenelektroden-Schicht 3 eine Kupferleitpaste auf die Isolierschicht gerakelt und anschließend einer Wärmebehandlung bei 100 - 150 °C für max. 0,5 h unterzogen werden. Die Schichtdicken der Rückseitenelektroden-Schicht 3 liegen dabei jeweils zwischen 400 und 800 nm.

Auf die Rückseitenelektroden-Schicht 3 wird nun die Lochleiter-Schicht 4, in der Fachsprache auch "p-Halbleiter" genannt, aufgetragen. Dazu wird in Wasser oder Ethanol gelöstes PEDOT-PSS (Poly(3,4)-ethylendioxithiophen - Polystyrolsulfonat) im Sieb- oder Tintenstrahldruck auf die Rückseitenelektroden-Schicht gedruckt.

Auf der Lochleiter-Schicht 4 wird daraufhin die photovoltaisch aktive Schicht 5 aufgebracht, die hier aus Pe-rowskit (ABX$_3$; A= (CH$_3$)$_2$CHNH$_2$; B=Ni; X=Cl, Br, I) besteht. Dazu wird eine Lösung von zum Beispiel 218,53 g NiBr$_2$ + 59,1 g (CH$_3$)$_2$CHNH$_2$ + 80,91 g HBr in einem 500 ml Becherglas mit 200 ml Lösungsmittel (90 % Ethanol; 10 % destilliertes Wasser) für 0,5 h bei 50 °C gerührt. Anschließend werden weitere 6 g (CH$_3$)$_2$CHNH$_2$ sowie 8 g HBr im Überschuss hinzugegeben und weiter gerührt. Nach weiteren 0,25 h ist die Suspension zur Verarbeitung bereit und wird auf die Lochleiter-Schicht 4 aufgerakelt. Anschließend erfolgt eine Wärmebehandlung bei 120 °C, bis das Lösungsmittel vollständig verdampft ist und der kristalline Perowskit (CH$_3$)$_2$CHNH$_3$NiBr$_3$) entstanden ist. Die entstehende Trockenfilmdichte liegt zwischen 200 nm und 1000 nm.

Auf die so erhaltene photovoltaisch aktive Schicht 5 wird durch Rollenapplikation einer 20 Gew.-% Lösung von Ti(OCH(CH$_3$)$_2$)$_4$ in Ethanol (CH$_3$CH$_2$OH) mit anschließender Wärmebehandlung bei 380 °C bis 450 °C (4h) die Elektronenleiter-Schicht 6 erzeugt.

Auf der Elektronenleiter-Schicht 6 wird nun die transparente elektrisch leitfähige Frontseitenelektroden-Schicht 7 in der Weise erzeugt, wie sie in der US 2009/242231 A1 beschrieben ist.

Schließlich wird auf der Frontseitenelektroden-Schicht 7 die transparente Schutzschicht 8 erzeugt, indem eine PET-Folie oder alternativ eine PET/ETFE-Copolymer-Folie (PET: Polyethylenterephthalat; ETFE: Ethylen-Tetrafluorethylen) auf die Frontseitenelektroden-Schicht 7 aufgebracht wird.

Beispiel 2 (Bedampfungs-Route)

Auf ein als Träger 1 dienendes Stahlflachprodukt wird als Isolierschicht 2 durch Elektronenstrahlbedampfung eine 500 - 1500 nm dicke SiO2-Schicht aufgebracht.

Auf die Isolierschicht 2 wird dann ebenfalls mittels Elektronenstrahlbedampfung eine 200 - 500 nm dicke Silber- bzw. Kupferschicht abgeschieden, die als Rückseitenelektroden-Schicht 3 dient.

Auf die Rückseitenelektroden-Schicht 3 wird nun durch thermisches Verdampfen von spiro-OMeTAD (2,2',7,7'-Tetrakis[N,N-di-(4-methoxyphenyl)amino]-9,9'-spirobifluorene) bei 100 - 200 °C und einem Druck von 10$^{-6}$ mbar eine Loch-Leiterschicht 4 aufgetragen.

Die hier ebenfalls als Perowskit-Schicht (ABX$_3$; A= (CH$_3$)$_2$CHNH$_2$; B=Zn; X=Cl, Br, I) ausgebildete photovoltaisch aktive Schicht 5 wird aus festen zum Verdampfen vorgesehenen Salzen NiX$_2$ und (CH$_3$)$_2$CHNH$_3$X (Ammoniumsalz durch Reaktion des Amins mit der Halogensäure: (CH$_3$)$_2$CHNH$_2$ + HX → (CH$_3$)$_2$CHNH$_3$X) erzeugt. Dazu werden bei-spielsweise gleichzeitig die beiden Salze ZnI$_2$ sowie (CH$_3$)$_2$CHNH$_3$I per physikalischer Dampfphasenabscheidung (ther-mische Verdampfung) auf die Lochleiter-Schicht 4 bei einem Druck von 10$^{-6}$ mbar aufgedampft. Die verwendete Ver-dampfungstemperatur für das ZnI$_2$ liegt zwischen 400 °C und 500 °C, wogegen das (CH$_3$)$_2$CHNH$_3$I bei Temperaturen

zwischen 100 °C und 175 °C verdampft wird. Nach dem Aufdampfen werden die entstandenen Schichten noch weitere 0,5 - 1,5 h bei Temperaturen von 80 °C bis 125 °C wärmebehandelt. Die Dicke der so erhaltenen photovoltaisch aktiven Schicht liegt bei 400 - 1250 nm.

Die Elektronenleiter-Schicht 6, in der Fachsprache auch n-Halbleiter-Schicht genannt, wird nun auf der photovoltaisch aktiven Schicht 5 durch Magnetronsputtern von $TiO_2$ bei $10^{-7}$ mbar für 5 Minuten und anschließendes Wärmebehandeln bei 300 °C bis 380 °C erzeugt. Die Dicke der so erhaltenen Schicht 6 liegt bei 150 bis 350 nm.

Die transparente Frontseitenelektroden-Schicht 7 wird durch Magnetronsputtern von ITO (Indium-Zinn-Oxid) bei $10^{-7}$ mbar oder Magnetronsputtern von FTO (Fluor-Zinn-Oxid) bei $10^{-7}$ mbar bei einer Substrattemperatur von 100 - 160 °C und einer Leistungsdichte von 1,5 bis 5,5 $W/cm^2$ erzeugt. Die erhaltene Schicht 7 weist Schichtdicken von 100 - 500 nm auf.

Schließlich wird auf der Frontseitenelektroden-Schicht 7 durch Elektronenstrahlbedampfung von Quarz ($SiO_2$) die hier 1500 - 4000 nm dicke $SiO_2$ Schutzschicht 8 erzeugt.

Tabelle 1

| Metallorganische Perowskite der allgemeinen Formel $ABX_3$ | | |
|---|---|---|
| "A" organisches Ammoniummolekül der Form $R-NH_3^+$; einwertig (+I), -R kann ein Alkyl- oder Arylrest sein, der unterschiedlich viele Kohlenstoffatome enthält | "B" Zentralatom, zweiwertig (+II) oder fünfwertig (+V) | "X" Anion, einwertig (-I) (Halogenide: $F^-$, $Cl^-$, $Br^-$, $I^-$, Pseudohalogenide $SCN^-$, $OCN^-$, $CN^-$) **alternativ** zweiwertig (-II) (Chalkogenide, $O2^-$, $S2^-$, $Se2^-$, $Te2^-$) |
| A (+I) | B (+II) | X3 (-I) |
| $R-NH_3$ | Si | $F^-$, $Cl^-$, $Br^-$, $I^-$, $SCN^-$, $CN^-$, $OCN^-$ |
| $R-NH_3$ | Ge | $F^-$, $Cl^-$, $Br^-$, $I^-$, $SCN^-$, $CN^-$, $OCN^-$ |
| $R-NH_3$ | Pb | $F^-$, $Cl^-$, $Br^-$, $I^-$, $SCN^-$, $CN^-$, $OCN^-$ |
| A (+I) | B (+V) | X3 (-II) |
| $R-NH_3$ | P | $O^{2-}$, $S^{2-}$, $Se^{2-}$, $Te^{2-}$ |
| $R-NH_3$ | As | $O^{2-}$, $S^{2-}$, $Se^{2-}$, $Te^{2-}$ |
| $R-NH_3$ | Sb | $O^{2-}$, $S^{2-}$, $Se^{2-}$, $Te^{2-}$ |
| $R-NH_3$ | Bi | $O^{2-}$, $S^{2-}$, $Se^{2-}$, $Te^{2-}$ |
| A (+I) | B (+II) | X3 (-I) |
| $R-NH_3$ | Zn | $F^-$, $Cl^-$, $Br^-$, $I^-$, $SCN^-$, $CN^-$, $OCN^-$ |
| $R-NH_3$ | Cd | $F^-$, $Cl^-$, $Br^-$, $I^-$, $SCN^-$, $CN^-$, $OCN^-$ |
| $R-NH_3$ | Hg | $F^-$, $Cl^-$, $Br^-$, $I^-$, $SCN^-$, $CN^-$, $OCN^-$ |
| $R-NH_3$ | Cu | $F^-$, $Cl^-$, $Br^-$, $I^-$, $SCN^-$, $CN^-$, $OCN^-$ |
| $R-NH_3$ | Ag | $F^-$, $Cl^-$, $Br^-$, $I^-$, $SCN^-$, $CN^-$, $OCN^-$ |
| $R-NH_3$ | Au | $F^-$, $Cl^-$, $Br^-$, $I^-$, $SCN^-$, $CN^-$, $OCN^-$ |
| $R-NH_3$ | Ni | $F^-$, $Cl^-$, $Br^-$, $I^-$, $SCN^-$, $CN^-$, $OCN^-$ |
| $R-NH_3$ | Pd | $F^-$, $Cl^-$, $Br^-$, $I^-$, $SCN^-$, $CN^-$, $OCN^-$ |
| $R-NH_3$ | Pt | $F^-$, $Cl^-$, $Br^-$, $I^-$, $SCN^-$, $CN^-$, $OCN^-$ |
| $R-NH_3$ | Co | $F^-$, $Cl^-$, $Br^-$, $I^-$, $SCN^-$, $CN^-$, $OCN^-$ |
| $R-NH_3$ | Rh | $F^-$, $Cl^-$, $Br^-$, $I^-$, $SCN^-$, $CN^-$, $OCN^-$ |
| $R-NH_3$ | Ir | $F^-$, $Cl^-$, $Br^-$, $I^-$, $SCN^-$, $CN^-$, $OCN^-$ |
| $R-NH_3$ | Fe | $F^-$, $Cl^-$, $Br^-$, $I^-$, $SCN^-$, $CN^-$, $OCN^-$ |
| $R-NH_3$ | Ru | $F^-$, $Cl^-$, $Br^-$, $I^-$, $SCN^-$, $CN^-$, $OCN^-$ |

(fortgesetzt)

| Metallorganische Perowskite der allgemeinen Formel ABX$_3$ | | |
|---|---|---|
| "A"<br>organisches Ammoniummolekül der Form R-NH$_3^+$; einwertig (+I), -R kann ein Alkyl- oder Arylrest sein, der unterschiedlich viele Kohlenstoffatome enthält | "B"<br>Zentralatom, zweiwertig (+II) oder fünfwertig (+V) | "X"<br>Anion, einwertig (-I) (Halogenide: F-, Cl-, Br-, I-, Pseudohalogenide SCN-, OCN-, CN-)<br>**alternativ** zweiwertig (-II) (Chalkogenide, O2-, S2-, Se2-, Te2-) |
| R-NH$_3$ | Os | F⁻, Cl⁻, Br⁻, I⁻, SCN⁻, CN⁻, OCN⁻ |
| R-NH$_3$ | Mn | F⁻, Cl⁻, Br⁻, I⁻, SCN⁻, CN⁻, OCN⁻ |
| R-NH$_3$ | Tc | F⁻, Cl⁻, Br⁻, I⁻, SCN⁻, CN⁻, OCN⁻ |
| R-NH$_3$ | Re | F⁻, Cl⁻, Br⁻, I⁻, SCN⁻, CN⁻, OCN⁻ |
| R-NH$_3$ | Cr | F⁻, Cl⁻, Br⁻, I⁻, SCN⁻, CN⁻, OCN⁻ |
| R-NH$_3$ | Mo | F⁻, Cl⁻, Br⁻, I⁻, SCN⁻, CN⁻, OCN⁻ |
| R-NH$_3$ | W | F⁻, Cl⁻, Br⁻, I⁻, SCN⁻, CN⁻, OCN⁻ |
| R-NH$_3$ | V | F⁻, Cl⁻, Br⁻, I⁻, SCN⁻, CN⁻, OCN⁻ |
| R-NH$_3$ | Nb | F⁻, Cl⁻, Br⁻, I⁻, SCN⁻, CN⁻, OCN⁻ |
| R-NH$_3$ | Ta | F⁻, Cl⁻, Br⁻, I⁻, SCN⁻, CN⁻, OCN⁻ |
| R-NH$_3$ | Ti | F⁻, Cl⁻, Br⁻, I⁻, SCN⁻, CN⁻, OCN⁻ |
| R-NH$_3$ | Zr | F⁻, Cl⁻, Br⁻, I⁻, SCN⁻, CN⁻, OCN⁻ |
| R-NH$_3$ | Hf | F⁻, Cl⁻, Br⁻, I⁻, SCN⁻, CN⁻, OCN⁻ |

Tabelle 2

| Schicht | Funktion | Herstellungs-/ Applikationsmethode(n) | Material(ien) |
|---|---|---|---|
| Träger | Unterstützung des photovoltaischen Schichtaufbaus | Erzeugen durch Kaltwalzen eines geeigneten Stahlvorprodukts (Warmband) | Stahl, insbesondere Edelstahl |
| Isolierschicht | Elektrische Isolierung | 1. Rollenapplikation (Lack) alternativ<br>2. PVD (Quarz) | 1. Isolierlack,<br>2. Quarz (SiO$_2$) |
| Rückseitenelektrode | Kathode | PVD | metallisches Silber |
| Lochleiter | p-Halbleiter | a) spin-coating<br>b) trocknen | spiro-OMeTAD in Chlorbenzol |
| Photoaktive Schicht | photovoltaische Funktion | a) PVD der Precursoren<br>b) thermische Nachbehandlung | Perowskit-Funktionsschicht der Formel ABX$_3$<br>1. R-NH$_3$-X<br>2. BX$_2$ (B=Pb, Sn,... X=F, Cl, Br, I, CN, SCN, OCN) (s. Tabellen 1 a,1 b) |
| Elektronenleiter | Ladungstransport | 1a) Spin-coating<br>1b) Trocknen, Calcinieren alternativ<br>2a) Magnetron-Sputtern | 1. Ti(O-i-Pr)$_4$ alternativ<br>2.TiO$_2$ |

(fortgesetzt)

| Schicht | Funktion | Herstellungs-/ Applikationsmethode(n) | Material(ien) |
|---------|----------|----------------------------------------|---------------|
| Frontseitenelektrode | Anoden (transparent) | Magnetron-Sputtern | FTO (fluorinated tin-oxide), ITO (indium-tin-oxide) |
| Schutzschicht | transparente Verkapselung | 1) PVD (Quarz) alternativ 2) Rollenkaschieren (Folie) | 1. Quarz ($SiO_2$) 2. transparente Folie / Verkapselungsfolie aus thermoplastischem Kunststoff |

**Patentansprüche**

1. Festkörper-Photovoltaikelement, mit

- einem Träger (1), der aus einem Stahlsubstrat besteht, und
- einem von dem Träger (1) getragenen photovoltaisch aktiven Schichtaufbau, wobei
- zwischen dem photovoltaisch aktiven Schichtaufbau und dem Träger (1) eine elektrisch isolierende, ionendiffusionshemmende Isolierschicht (2) angeordnet ist und
- der photovoltaisch aktive Schichtaufbau folgende wie folgt geschichtete Funktionsschichten umfasst:

- eine aus einem metallischen Werkstoff bestehende Rückseitenelektrode (3),
- einen Lochleiter (4),
- eine mindestens eine Perowskit-Schicht umfassende photovoltaisch aktive Schicht (5),
- einen Elektronenleiter (6),
- eine im sichtbaren Bereich des Lichts transparente Frontelektrode (7) und
- eine im sichtbaren Bereich des Lichts transparente Schutzschicht (8).

2. Photovoltaikelement nach Anspruch 1, **dadurch gekennzeichnet, dass**

- die Rückseitenelektrode (3),
- der Lochleiter (4), die photovoltaisch aktive Schicht (5) und der Elektronenleiter (6) als Gruppe gemeinsam, sowie
- die Frontelektrode (7)
jeweils mit einer Strukturierung versehen sind.

3. Photovoltaikelement nach Anspruch 1, **dadurch gekennzeichnet, dass**

- die Rückseitenelektrode (3) und der Lochleiter (4) gemeinsam,
- die photovoltaisch aktive Schicht (5) alleine, sowie
- der Elektronenleiter (6) und die Frontelektrode (7) gemeinsam
jeweils mit einer Strukturierung versehen sind.

4. Photovoltaikelement nach einem der voranstehenden Ansprüche, **dadurch gekennzeichnet, dass** der Träger (1) aus einem Stahl- oder Leichtmetall-Werkstoff besteht.

5. Photovoltaikelement nach einem der voranstehenden Ansprüche, **dadurch gekennzeichnet, dass** der Träger (1) ein metallisches Flachprodukt ist, das eine Trägerschicht bildet.

6. Photovoltaikelement nach Anspruch 5, **dadurch gekennzeichnet, dass** der Träger (1) 0,1 - 2 mm dick ist.

7. Photovoltaikelement nach einem der voranstehenden Ansprüche, **dadurch gekennzeichnet, dass** die Isolierschicht (2) aus einem organischen Werkstoff gebildet ist.

8. Photovoltaikelement nach einem der Ansprüche 1 bis 6, **dadurch gekennzeichnet, dass** die Isolierschicht (2) aus einem anorganischen Werkstoff gebildet ist.

9. Photovoltaikelement nach einem der voranstehenden Ansprüche, **dadurch gekennzeichnet, dass** die Rückseitenelektroden-Schicht (3) aus einem Metallwerkstoff besteht, dessen Hauptbestandteil Aluminium, Gold, Kupfer oder Silber ist.

10. Photovoltaikelement nach Anspruch 9, **dadurch gekennzeichnet, dass** die mindestens eine photovoltaisch aktive Schicht (5) eine Perowskitstruktur der Formel $ABX_3$ umfasst, wobei in dieser Formel

"A" eine monovalent positiv geladene organische Ammoniumverbindung der Form $N^+R_1R_2R_3R_4$ bezeichnet, wobei "$R_1,R_2,R_3,R_4$" unabhängig voneinander H oder ein Alkylrest oder ein Arylrest sind,
"B" ein divalentes oder pentavalentes Metallkation, ausgewählt aus der Gruppe "$Si^{2+}$, $Ge^{2+}$, $Pb^{2+}$, $P^{5+}$, $As^{5+}$, $Sb^{5+}$, $Bi^{5+}$, $Zn^{2+}$, $Cd^{2+}$, $Hg^{2+}$, $Cu^{2+}$, $Ag^{2+}$, $Au^{2+}$, $Ni^{2+}$, $Pd^{2+}$, $Pt^{2+}$, $Co^{2+}$, $Rh^{2+}$, $Ir^{2+}$, $Fe^{2+}$, $Ru^{2+}$, $Os^{2+}$, $Mn^{2+}$, $Tc^{2+}$, $Re^{2+}$, $Cr^{2+}$, $Mo^{2+}$, $W^{2+}$, $V^{2+}$, $Nb^{2+}$, $Ta^{2+}$, $Ti^{2+}$, $Zr^{2+}$ oder $Hf^{2+}$", ist

und

"X" ein monovalentes oder divalentes Anion, ausgewählt aus der Gruppe "$F^-$, $Cl^-$, $Br^-$, $I^-$, $SCN^-$, $OCN^-$, $CN^-$, $O^{2-}$, $S^{2-}$, $Se^{2-}$ oder $Te^{2-}$", ist.

11. Photovoltaikelement nach Anspruch 10, **dadurch gekennzeichnet, dass** die Perowskitstruktur eine Bandlücke Eg im sichtbaren oder nahinfraroten Bereich aufweist.

12. Photovoltaikelement nach Anspruch 10 oder 11, **dadurch gekennzeichnet, dass** für die Perowskitstruktur $ABX_3$ ein Toleranzfaktor t von 0,8 - 1,2 gilt, der nach folgender Formel berechnet wird:

$$t = \left(r_A + r_X\right) / \left(\sqrt{2}\left(r_B + r_X\right)\right)$$

13. Photovoltaikelement nach einem der voranstehenden Ansprüche, **dadurch gekennzeichnet, dass** die Isolierschicht (2) mittels Rollenapplikation oder Gasphasenabscheidung auf den Träger appliziert ist.

14. Photovoltaikelement nach einem der voranstehenden Ansprüche, **dadurch gekennzeichnet, dass** die Applikation der Rückseitenelektroden-Schicht (3) auf die Isolierschicht (2) mittels eines Gasphasenabscheidungsverfahrens erfolgt.

8
7 + P3
6
5 } + P2
4
3 + P1
2
1

**Fig. 1**

8
7 } + P3
6
5 + P2
4
3 } + P1
2
1

**Fig. 2**

Europäisches
Patentamt

European
Patent Office

Office européen
des brevets

# EUROPÄISCHER RECHERCHENBERICHT

**Nummer der Anmeldung**

EP 15 18 5466

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2015/031944 A1 (DYESOL LTD [AU]) 12. März 2015 (2015-03-12) * Zusammenfassung * * Seite 6, Zeile 18 - Seite 12, Zeile 32 * * Seite 19, Zeile 16 - Seite 20, Zeile 32 * * Abbildungen 1,6 * | 1-14 | INV. H01L51/42 |
| A,D | EP 2 605 280 A1 (THYSSENKRUPP STEEL EUROPE AG [DE]) 19. Juni 2013 (2013-06-19) * Zusammenfassung * * Spalte 6, Absatz 24 - Spalte 7, Absatz 28 * * Abbildung 4 * | 1-14 | |
| A | CARNIE MATTHEW J ET AL: "Identifying recombination mechanisms through materials development in perovskite solar cells", 2015 IEEE 42ND PHOTOVOLTAIC SPECIALIST CONFERENCE (PVSC), IEEE, 14. Juni 2015 (2015-06-14), Seiten 1-3, XP032828909, DOI: 10.1109/PVSC.2015.7355675 [gefunden am 2015-12-14] * Zusammenfassung * * Abbildung 1 * | 1-14 | RECHERCHIERTE SACHGEBIETE (IPC) H01L |

Der vorliegende Recherchenbericht wurde für alle Patentansprüche erstellt

| Recherchenort | Abschlußdatum der Recherche | Prüfer |
|---|---|---|
| Berlin | 19. Februar 2016 | Ekoué, Adamah |

EPO FORM 1503 03.82 (P04C03)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

**ANHANG ZUM EUROPÄISCHEN RECHERCHENBERICHT
ÜBER DIE EUROPÄISCHE PATENTANMELDUNG NR.**

EP 15 18 5466

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-02-2016

| Im Recherchenbericht angeführtes Patentdokument | Datum der Veröffentlichung | Mitglied(er) der Patentfamilie | Datum der Veröffentlichung |
|---|---|---|---|
| WO 2015031944 A1 | 12-03-2015 | AU 2014317801 A1<br>WO 2015031944 A1 | 11-02-2016<br>12-03-2015 |
| EP 2605280 A1 | 19-06-2013 | DE 102011121165 A1<br>EP 2605280 A1 | 20-06-2013<br>19-06-2013 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2693503 A1
- EP 2605280 A1
- US 2009242231 A1